# EUROPÄISCHE PATENTSCHRIFT

(11) **EP 3 839 109 B1**
(45) Veröffentlichungstag und Bekanntmachung des Hinweises auf die Patenterteilung: **05.10.2022**
(21) Anmeldenummer: 20000461.2
(22) Anmeldetag: 11.12.2020
(51) Int. Cl.: C30B 29/42, C30B 25/16, C30B 29/40, H01L 21/02, H01L 29/36, H01L 29/861

(54) **GASPHASENEPITAXIEVERFAHREN**
GAS PHASE EPITAXY METHOD
PROCÉDÉ D'ÉPITAXIE EN PHASE GAZEUSE

(30) Priorität: 20.12.2019 DE 102019008928
(43) Veröffentlichungstag der Anmeldung: 23.06.2021
(73) Patentinhaber: AZUR SPACE Solar Power GmbH, 74072 Heilbronn (DE)
(72) Erfinder: Wächter, Clemens, 74348 Lauffen am Neckar (DE); Keller, Gregor, 74080 Heilbronn (DE)
(74) Vertreter: Koch Müller Patentanwaltsgesellschaft mbH

(56) Entgegenhaltungen:
- US-A- 4 855 250
- US-A- 5 824 151

## Beschreibung

Es sind die unterschiedlichsten Gasphasenepitaxie-Anlagen, z.B. von der Fa. Aixtron, zum epitaktischen Erzeugen von Halbleiterschichten bekannt.

Den Verfahren ist typischerweise gemein, dass eine Reaktionskammer zum Einbringen eines Substrats geöffnet, anschließend geschlossen, abgepumpt und ausreichend aufgeheizt wird, um dann durch einen in die Reaktionskammer eingeleiteten Gasfluss ein Aufwachsen von Halbleiterschichten auf einer Oberfläche des Substrats zu bewirken.

Die Zusammensetzung des Gasflusses richtet sich nach der Art der zu wachsenden Schicht, wobei typischerweise Präkursoren, wie Arsin und/oder TMGa, die Elemente für die zu wachsende Halbleiterschicht liefern und für eine Dotierung der Schicht gegebenenfalls auch Präkursoren für einen Dotierstoff Verfahren für eine Gasphasenepitaxie sind aus der US4 855 250 A und aus der US5 824 151 A bekannt

Vor diesem Hintergrund besteht die Aufgabe der Erfindung darin, ein Verfahren anzugeben, das den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Gasphasenepitaxieverfahren bereitgestellt, aufweisend folgende Verfahrensschritten:
- Bereitstellen eines III-V-Substrats eines ersten Leitfähigkeitstyps,
- Einbringen des III-V-Substrats in eine Reaktionskammer einer Gasphasenepitaxie-Anlage bei einer Beladetemperatur T_{B},
- Aufheizen des III-V-Substrats von der Beladetemperatur T_{B} auf eine Epitaxie-Temperatur T_{E} unter Einleiten eines Initial-Gasflusses aufweisend ein Trägergas und einen ersten Präkursor für ein erstes Element aus der V. Hauptgruppe,
- Abscheiden einer III-V-Schicht mit einer Dotierstoffkonzentration eines Dotierstoffs des ersten Leitfähigkeitstyps auf einer Oberfläche des III-V-Substrats aus der Gasphase aus einem in die Reaktionskammer geleiteten Epitaxie-Gasflusses aufweisend das Trägergas, den ersten Präkursor und mindestens einen zweiten Präkursor für ein Element der III. Hauptgruppe, wobei die III-V-Schicht mit einer von 10¹⁷ cm⁻³ bis auf 10¹⁵ cm ⁻³ abnehmenden Dotierstoffkonzentration (Dmax, Dmin) aufgewachsen wird.

Außerdem wird während des Aufheizens von der Beladetemperatur T_{B} auf die Epitaxie-Temperatur T_{E} dem Initial-Gasfluss ein dritter Präkursor für einen Dotierstoff des ersten Leitfähigkeitstyps wenigstens zeitweise zugegeben. Vorzugsweise wird der dritte Präkursor während des gesamten Aufheizvorgangs dazugegeben.

Es versteht sich, dass ein III-V Substrat mindestens eine Komponente der III. Hauptgruppe und mindestens eine Komponente der V. Hauptgruppe aufweist. Das Substrat besteht beispielsweise aus GaAs.

Als Beladetemperatur wird die Temperatur bezeichnet, bei welcher die Reaktionskammer geöffnet und das Substrat in der Kammer angeordnet wird. Es versteht sich, dass sich die Beladetemperatur nach der Technik des Beladens richtet. So muss die Beladetemperatur für ein manuelles Beladen typischerweise deutlich tiefer sein als für ein Beladen per Roboter. Epitaktisches Wachstum tritt bei der Beladetemperatur typischerweise noch nicht auf.

Als Epitaxie-Temperatur wird die Temperatur bezeichnet, welche für den Aufwachsprozess gewählt wird und ein zuverlässiges Wachstum sicherstellt.

Es versteht sich, dass ein Kristallwachstum auch bei höheren und niedrigeren Temperaturen bzw. innerhalb eines Temperaturfensters möglich ist.

Als Präkursor werden Moleküle bezeichnet, welche als Ausgangsprodukt für das epitaktische Wachstum dienen. Ein Präkursor ist entsprechend ein Molekül bestehend aus einem aufzuwachsenden Element, z.B. einem Element der III. oder V. Hauptgruppe, und mindestens einem weiteren Element.

Als Trägergas für die Gasflüsse eignet sich beispielsweise H₂ oder N₂. Der Initialgasfluss mit dem Trägergas und dem Präkursor für ein erstes Element aus der V. Hauptgruppe, z.B. Arsin, wird während des Aufheizens in die Reaktionskammer eingeleitet, um ein Ausdiffundieren eines entsprechenden Elements der V. Hauptgruppe, z.B. Arsen, aus dem III-V-Substrat zu unterdrücken. Man spricht auch davon , die Schichten, also Substratoberflächen, zu stabilisieren.

Die weitere Zugabe eines Dotierstoffs des ersten Leitfähigkeitstyps bzw. eines entsprechenden dritten Präkursors zu dem Initial-Gasfluss verhindert, dass sich während des Aufheizvorgangs eine - wenn auch dünne - mit dem zweiten Leitfähigkeitstyp dotierte Schicht an der Substratoberfläche ausbildet. Dotierstoffe des zweiten Leitfähigkeitstyps und/oder Elemente der III. Hauptgruppe sind beispielsweise aufgrund vorausgegangener Nutzungen der Epitaxie-Anlage als Hintergrund/Verunreinigung in der Reaktionskammer vorhanden bzw. abgelagert.

Durch das Aufheizen dampfen die abgelagerten Elemente und Dotierstoffe ab. Zusammen mit dem Arsin, d.h. Abdampfen aus der Oberfläche der Halbleiterscheibe kann es so bereits während des Aufheizprozesses zu einem ungewünschten Aufwachsen einer gegebenenfalls sehr dünnen Schicht kommen.

Je niedriger die aufzuwachsende III-V-Schicht dotiert werden soll, umso relevanter ist der Einfluss einer solchen ungewollten mit dem zweiten Leitfähigkeitstyp dotierten Schicht, nämlich eine in Durchlassrichtung anfangs auch für höhere Spannungswerte weiterhin sperrende Wirkung.

Gerade bei Bauteilen mit niedrig dotierten Schichten für eine hohe Spannungsfestigkeit führt das erfindungsgemäße Verfahren daher dazu, dass die Kennlinie der Bauteile auch in Durchlassrichtung zuverlässig höchstens geringfügig von einem idealen Kennlinienverlauf abweicht.

Gemäß einer ersten Ausführungsform beginnt die Zugabe des dritten Präkursors während des Aufheizens unterhalb einer Temperatur von 500°C oder unterhalb einer Temperatur von 400°C oder unterhalb von einer Temperatur von 300°C. Hierdurch wird sichergestellt, dass kein epitaktisches Wachstum stattfinden kann, bevor der dritte Präkursor zugegeben wird.

In einer Weiterbildung beginnt die Zugabe des dritten Präkursors während des Aufheizens ab einer Temperatur von mindestens 150°C oder mindestens ab einer Temperatur von 200°C.

In einer anderen Ausführungsform beträgt ein Gesamtmassefluss des Initial-Gasflusses höchstens 10% eines Gesamtmasseflusses des Epitaxie-Gasflusses.

Gemäß einer weiteren Ausführungsform wird als Reaktionskammer ein Planetenreaktor verwendet.

In einer anderen Weiterbildung wird ein III-V-Substrat mit einer Dotierstoffkonzentration von mindestens 1·10¹⁷ cm⁻³ oder von mindestens 10¹⁸ cm⁻³ bereitgestellt.

Gemäß einer weiteren Weiterbildung wird die III-V Schicht mit einer von 10¹⁸ cm⁻³ bis auf 10¹⁵ cm⁻³ abnehmenden Dotierstoffkonzentration aufgewachsen.

In einer anderen Ausführungsform wird die III-V Schicht mit einer Schichtdicke von höchstens 10 µm oder von höchstens 30 µm oder höchstens 60 µm aufgewachsen.

In einer Weiterbildung weist die III-V Schicht eine Schichtdicke von mindestens 10 µm oder mindestens 30 µm auf. Vorzugsweise weist die III-V Schicht eine Schichtdicke in einem Bereich zwischen 10 µm und 60 µm auf..

In einer weiteren Ausführungsform ist der erste Leitfähigkeitstyp p oder n.

Gemäß einer anderen Weiterbildung wird die III-V Schicht stoffschlüssig auf die Oberfläche des III-V-Substrats aufgewachsen.

In einer anderen Weiterbildung wird die Dotierstoffkonzentration innerhalb der III-V-Schicht mittels eines Verhältnisses eines Massestroms des ersten Präkursors zu einem Massestrom des zweiten Präkursors und/oder mittels eines dem Epitaxie-Gasfluss zugegebenen Masseflusses des dritten Präkursors eingestellt.

Die Dotierung einer III-V-Schicht ist bei Verwendung geeigneter Dotierstoffe, z.B. Kohlenstoff, auch von dem Verhältnis zwischen dem Element der III. Hauptgruppe und dem Element der V. Hauptgruppe abhängig.

Der Dotierstoff wird dabei in Form eines weiteren Präkursors für einen entsprechenden Dotierstoff, z.B. Kohlenstofftetrabromid, oder mittels eines metallorganischen Präkursors, beispielsweise dem zweiten Präkursor für das Element der III. Hauptgruppe, z.B. TMGa, bereitgestellt.

Wird ein Präkursor für einen Dotierstoff zugefügt, so spricht man von aktiver Dotierung, während ein Dotieren mittels des Kohlenstoffs eines metallorganischen Präkursors als Autodotierung bezeichnet wird.

Gemäß einer weiteren Ausführungsform ist der dritte Präkursor Dimethylzink oder Diethylzink oder Kohlenstofftetrabromid oder 1,2-Biscyclopentadienylmagnesium oder Monosilan oder Disilan oder Dimethyltellurid oder Diethyltellurid oder Di-isopropyltellurid.

In einer weiteren Weiterbildung weist das Substrat über eine Schichtdicke eine konstante Dotierstoffkonzentration oder eine sich um höchstens 1% ändernde Dotierstoffkonzentration oder eine sich um höchstens 10% ändernde Dotierstoffkonzentration auf.

In einer anderen Ausführungsform umfasst das III-V-Substrat GaAs oder es besteht aus GaAs.

Gemäß einer anderen Weiterbildung weist die Epitaxie-Temperatur T_{E} mindestens 550°C oder mindestens 600°C und höchstens 900°C auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine Aufsicht auf in einer Reaktionskammer angeordnete Substrate während eines Aufheizvorgangs,
- Figur 2: einen Temperaturverlauf einer ersten erfindungsgemäße Ausführungsform eines Aufheizvorgangs,
- Figur 3: einen Dotierstoffkonzentrationsverlauf über ein III-V-Substrat und eine sich anschließende III-V-Schicht,
- Figur 4: Verläufe von Kennlinien.

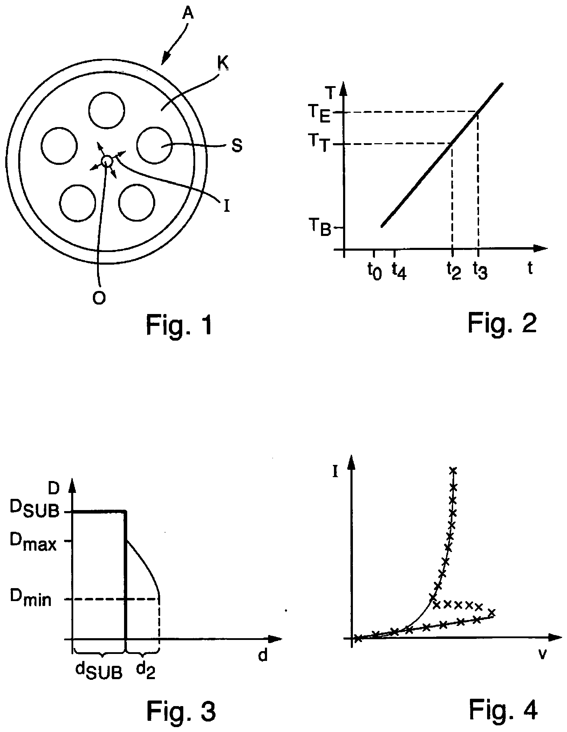

Die Abbildung der Figur 1 zeigt eine Schnittansicht von oben auf eine als Planetenreaktor ausgebildete Reaktorkammer K einer Gasphasenepitaxie-Anlage A mit mehreren darin angeordneten III-V-Substraten und einem Gaseinlassorgan O, durch welches zum Abscheiden einer III-V-Schicht ein Epitaxie-Gasfluss in die Reaktorkammer K eingeleitet wird.

Der Epitaxie-Gasfluss weist zumindest ein Trägergas, einen ersten Präkursor für ein Element der V. Hauptgruppe und einen zweiten Präkursor für ein Element der III. Hauptgruppe auf.

Nach dem Beladen der Reaktorkammer K bei einer Beladetemperatur T_{B} wird, wird die Reaktorkammer geschlossen, abgepumpt und aufgeheizt.

Während des Aufheizens der Reaktorkammer wird durch das Gaseinlassorgan O ein Initial-Gasfluss I in die Reaktorkammer K geleitet.

Das Aufheizen folgt beispielsweise dem in der Abbildung der Figur 2 dargestellten Temperaturverlauf, wobei der Initial-Gasfluss I zu einem Zeitpunkt t0 bei der Beladetemperatur T_{B} das Trägergas und einen ersten Präkursor für ein Element der V. Hauptgruppe umfasst.

Ab Erreichen einer Trigger-Temperatur T_{T} zu einem Zeitpunkt t2 und bis zu dem Erreichen einer Epitaxie-Temperatur T_{E} wird dem Initial-Gasfluss zusätzlich ein dritter Präkursor für einen Dotierstoff des ersten Leitfähigkeitstyps zugegeben.

Es versteht sich, dass die Trigger-Temperatur T_{T} kleiner als die Epitaxie-Temperatur T_{E} und der Zeitpunkt t₂ zeitlich vor dem Zeitpunkt t₃ liegt. Die Trigger-Temperatur T_{T} beträgt beispielsweise 500°C oder 400°C.

Alternativ entspricht die Trigger-Temperatur T_{T} der Beladetemperatur T_{B}, so dass der dritte Präkursor bereits von dem Zeitpunkt t₂=t₀ an, also von Beginn an, in dem Initial-Gasfluss I enthalten ist.

Es sei zur Vollständigkeit angemerkt, dass ein Gasfluss vor Beladung sicherheitstechnisch nicht möglich ist.

In der Abbildung der Figur 3 ist ein Verlauf einer Dotierstoffkonzentration des ersten Leitfähigkeitstyps D über eine Dicke d des III-V-Substrats und der III-V-Schicht dargestellt. Das bereitgestellte III-V-Substrat weist über eine Dicke d_{SUB} eine konstante Dotierstoffkonzentration D_{SUB} des ersten Leitfähigkeitstyps auf.

Durch Zugabe des dritten Präkursors während des Aufheizens beginnt die Dotierung der auf dem III-V-Substrat S aufgewachsenen III-V-Schicht direkt anschließend an das III-V-Substrat S mit einer Dotierstoffkonzentration Dₘₐₓ des ersten Leitfähigkeitstyps. Über eine Schichtdicke d_{L} der III-V-Schicht nimmt die Dotierstoffkonzentration bis zu einer Dotierstoffkonzentration Dₘᵢₙ ab.

Aufgrund des durch das erfindungsgemäße Verfahren erreichten Dotierstoffkonzentrationsverlaufs ergibt sich für ein durch eine Schicht des zweiten Leitfähigkeitstyps ergänztes Bauelement (Diode) in Durchlassrichtung ein dem idealen Verlauf folgende Diodenkennlinie, die als durchgezogene Linie in der Abbildung der Figur 4 beispielhaft dargestellt ist.

Ohne die Zugabe des dritten Präkursors während des Aufheizens kann sich gegebenenfalls zwischen dem Substrat des ersten Leitfähigkeitstyps und der in dem nachfolgenden Abscheideschritt aufgewachsenen Schicht des ersten Leitfähigkeitstyps eine dünne unerwünschte Schicht, d.h. eine Zwischenschicht, des zweiten Leitfähigkeitstyps ausbilden.

Eine solche Schicht des zweiten Leitfähigkeitstyps führt für ein um eine weitere Schicht des zweiten Leitfähigkeitstyps ergänztes Bauelement (Diode) zu einem verlängerten Sperren in Durchlassrichtung und entsprechender rücklaufender Kennlinie, wie es der durch Kreuze dargestellte Verlauf in der Abbildung der Figur 4 verdeutlicht.

## Patentansprüche

1. Gasphasenepitaxieverfahren mit den Verfahrensschritten:
- Bereitstellen eines III-V-Substrats (S) eines ersten Leitfähigkeitstyps,
- Einbringen des III-V-Substrats (S) in eine Reaktionskammer (K) einer Gasphasenepitaxie-Anlage (A) bei einer Beladetemperatur T_{B},
- Aufheizen des III-V-Substrats (S) von der Beladetemperatur T_{B} auf eine Epitaxie-Temperatur T_{E} unter Einleiten eines Initial-Gasflusses (I) aufweisend ein Trägergas und einen ersten Präkursor für ein erstes Element aus der V. Hauptgruppe,
- Abscheiden einer III-V-Schicht mit einer Dotierstoffkonzentration (Dₘₐₓ, Dₘᵢₙ) eines Dotierstoffs des ersten Leitfähigkeitstyps auf einer Oberfläche des III-V-Substrats (S) aus der Gasphase aus einem in die Reaktionskammer geleiteten Epitaxie-Gasflusses aufweisend das Trägergas, den ersten Präkursor und mindestens einen zweiten Präkursor für ein Element der III. Hauptgruppe,
- während des Aufheizens von der Beladetemperatur T_{B} auf die Epitaxie-Temperatur T_{E} dem Initial-Gasfluss (I) ein dritter Präkursor für einen Dotierstoff des ersten Leitfähigkeitstyps zugegeben wird,
**dadurch gekennzeichnet, dass**
die III-V-Schicht mit einer von 10¹⁷ cm⁻³ bis auf 10¹⁵ cm⁻³ abnehmenden Dotierstoffkonzentration (Dₘₐₓ, Dₘᵢₙ) aufgewachsen wird.

2. Gasphasenepitaxieverfahren nach Anspruch 1, **dadurch gekennzeichnet, dass** die Zugabe des dritten Präkursors während des Aufheizens unterhalb einer Temperatur von 500 °C oder unterhalb einer Temperatur von 400 °C oder unterhalb von einer Temperatur von 300 °C beginnt.

3. Gasphasenepitaxieverfahren nach Anspruch 1 oder 2, **dadurch gekennzeichnet, dass** ein Gesamtmassefluss des Initial-Gasflusses höchstens 10 % eines Gesamtmasseflusses des Epitaxie-Gasflusses beträgt.

4. Gasphasenepitaxieverfahren nach einem der vorstehenden Ansprüche, **dadurch gekennzeichnet, dass** als Reaktionskammer (K) ein Planetenreaktor verwendet wird.

5. Gasphasenepitaxieverfahren nach einem der vorstehenden Ansprüche, **dadurch gekennzeichnet, dass** ein III-V-Substrat mit einer Dotierstoffkonzentration (D_{SUB}) von mindesten 1·10¹⁷ cm⁻³ oder von mindestens 1·10¹⁸ cm⁻³ bereitgestellt wird.

6. Gasphasenepitaxieverfahren nach einem der vorstehenden Ansprüche, **dadurch gekennzeichnet, dass** die III-V-Schicht mit einer Schichtdicke (d_{L}) von höchstens 30 µm aufgewachsen wird.

7. Gasphasenepitaxieverfahren nach einem der vorstehenden Ansprüche, **dadurch gekennzeichnet, dass** der erste Leitfähigkeitstyp p oder n ist.

8. Gasphasenepitaxieverfahren nach einem der vorstehenden Ansprüche, **dadurch gekennzeichnet, dass** die III-V-Schicht stoffschlüssig auf die Oberfläche des III-V-Substrats (S) aufgewachsen wird.

9. Gasphasenepitaxieverfahren nach einem der vorstehenden Ansprüche, **dadurch gekennzeichnet, dass** die Dotierstoffkonzentration (Dₘᵢₙ, Dₘₐₓ) innerhalb der III-V-Schicht mittels eines Verhältnisses eines Massestroms des ersten Präkursors zu einem Massestrom des zweiten Präkursors und/oder mittels eines dem Epitaxie-Gasfluss zugegebenen Masseflusses des dritten Präkursors eingestellt wird.

10. Gasphasenepitaxieverfahren nach einem der vorstehenden Ansprüche, **dadurch gekennzeichnet, dass** der dritte Präkursor Dimethylzink oder Diethylzink oder Kohlenstofftetrabromid oder 1,2-Biscyclopentadienylmagnesium oder Monosilan oder Disilan oder Dimethyltellurid oder Diethyltellurid oder Di-isopropyltellurid ist.

11. Gasphasenepitaxieverfahren nach einem der vorstehenden Ansprüche, **dadurch gekennzeichnet, dass** das III-V-Substrat (S) über eine Schichtdicke eine konstante Dotierstoffkonzentration oder eine sich um höchstens 1 % ändernde Dotierstoffkonzentration aufweist.

12. Gasphasenepitaxieverfahren nach einem der vorstehenden Ansprüche, **dadurch gekennzeichnet, dass** das III-V-Substrat GaAs umfasst oder aus GaAs besteht.

13. Gasphasenepitaxieverfahren nach einem der vorstehenden Ansprüche, **dadurch gekennzeichnet, dass** die Epitaxie-Temperatur T_{E} mindestens 550 °C oder mindestens 600 °C und höchstens 900°C aufweist.

14. Gasphasenepitaxieverfahren nach einem der vorstehenden Ansprüche, **dadurch gekennzeichnet, dass** die Zugabe des dritten Präkursors während des Aufheizens ab einer Temperatur von mindestens 150°C oder mindestens ab einer Temperatur von 200°C beginnt.

## Claims

1. Gas phase epitaxy method comprising the method steps:
- providing a III-V substrate (S) of a first conductivity type,
- introducing the III-V substrate (S) into a reaction chamber (K) of a gas phase epitaxy plant (A) at a loading temperature T_{B},
- heating the III-V substrate (S) from the loading temperature T_{B} to an epitaxy temperature T_{E} with introduction of an initial gas flow (I) comprising a carrier gas and a first precursor for a first element from the V main group,
- precipitating a III-V layer with a doping substance concentration (Dₘₐₓ, Dₘᵢₙ) of a doping substance of the first conductivity type on a surface of the III-V substrate (S) from the gas phase from an epitaxy gas flow which is conducted into the reaction chamber and comprises the carrier gas, the first precursor and at least one second precursor for an element of the III main group,
- adding a third precursor for a doping substance of the first conductivity type to the initial gas flow (I) during heating from the loading temperature T_{B} to the epitaxy temperature T_{E},
**characterised in that**
the III-V layer is epitaxially grown at a doping substance concentration (Dₘₐₓ, Dₘᵢₙ) decreasing from 10¹⁷ cm⁻³ to 10¹⁵ cm⁻³,

2. Gas phase epitaxy method according to claim 1, **characterised in that** the addition of the third precursor during the heating begins below a temperature of 500° C or below a temperature of 400° C or below a temperature of 300° C.

3. Gas phase epitaxy method according to claim 1 or 2, **characterised in that** a total mass flow of the initial gas flow is at most 10% of a total mass flow of the epitaxy gas flow.

4. Gas phase epitaxy method according to any one of the preceding claims, **characterised in that** a planetary reactor is used as reaction chamber (K).

5. Gas phase epitaxy method according to any one of the preceding claims, **characterised in that** a III-V substrate with a doping substance concentration (D_{SUB}) of at least 1·10¹⁷ cm⁻³ or at least 1·10¹⁸ cm⁻³ is provided.

6. Gas phase epitaxy method according to any one of the preceding claims, **characterised in that** the III-V layer is epitaxially grown at a layer thickness (d_{L}) of at most 30 µm.

7. Gas phase epitaxy method according to any one of the preceding claims, **characterised in that** the first conductivity type is p or n.

8. Gas phase epitaxy method according to any one of the preceding claims, **characterised in that** the III-V layer is epitaxially grown on the surface of the III-V substrate (S) with material bonding.

9. Gas phase epitaxy method according to any one of the preceding claims, **characterised in that** the doping substance concentration (Dₘᵢₙ, Dₘₐₓ) is set within the III-V layer by means of a ratio of a mass flow of the first precursor to a mass flow of the second precursor and/or by means of a mass flow of the third precursor added to the epitaxy flow.

10. Gas phase epitaxy method according to any one of the preceding claims, **characterised in that** the third precursor is dimethyl zinc or diethyl zinc or carbon tetrabromide or 1,2-biscyclopentadienyl magnesium or monosilane or disilane or dimethyltelluride or diethyltelluride or di-isopropyltelluride.

11. Gas phase epitaxy method according to any one of the preceding claims, **characterised in that** the III-V substrate (S) has over a layer thickness a constant doping substance concentration or a doping substance concentration changing by at most 1%.

12. Gas phase epitaxy method according to any one of the preceding claims, **characterised in that** the III-V substrate comprises GaAs or consists of GaAs.

13. Gas phase epitaxy method according to any one of the preceding claims, **characterised in that** the epitaxy temperature T_{E} comprises at least 550° C or at least 600° C and at most 900° C.

14. Gas phase epitaxy method according to any one of the preceding claims, **characterised in that** the addition of the third precursor during the heating begins from a temperature of at least 150° C or at least from a temperature of 200° C.

## Revendications

1. Procédé d'épitaxie en phase gazeuse comprenant les étapes de procédé suivantes :
- préparation d'un substrat III-V (S) d'un premier type de conductivité,
- introduction du substrat III-V (S) dans une chambre de réaction (K) d'une installation d'épitaxie en phase gazeuse (A) à une température de chargement T_{B},
- chauffage du substrat III-V (S) de la température de chargement T_{B} à une température d'épitaxie T_{E} avec introduction d'un flux gazeux initial (I) contenant un gaz porteur et un premier précurseur pour un premier élément du groupe V,
- séparation d'une couche III-V possédant une concentration d'agent de dopage (Dₘₐₓ, Dₘᵢₙ) d'un agent de dopage du premier type de conductivité sur une surface du substrat III-V (S) à partir de la phase gazeuse d'un flux de gaz d'épitaxie introduit dans la chambre de réaction contenant le gaz porteur, le premier précurseur et au moins un deuxième précurseur pour un élément du groupe III et,
- pendant le chauffage de la température de chargement T_{B} à la température d'épitaxie T_{E}, ajout au flux gazeux initial (I) d'un troisième précurseur pour un agent de dopage du premier type de conductivité
**caractérisé en ce que**
la couche III-V est accrue avec une concentration d'agent de dopage (Dₘₐₓ, Dₘᵢₙ) décroissant de 10¹⁷ cm⁻³ à 10¹⁵ cm⁻³.

2. Procédé d'épitaxie en phase gazeuse selon la revendication 1, **caractérisé en ce que** l'ajout du troisième précurseur pendant le chauffage commence au-dessous d'une température de 500 °C ou au-dessous d'une température de 400 °C ou au-dessous d'une température de 300 °C.

3. Procédé d'épitaxie en phase gazeuse selon la revendication 1 ou 2, **caractérisé en ce**
**qu'**un flux massique total du flux gazeux initial est égal à 10% maximum d'un flux massique total du flux gazeux d'épitaxie.

4. Procédé d'épitaxie en phase gazeuse selon une des revendications précédentes, **caractérisé en ce qu'**un réacteur planétaire est utilisé en guise de chambre de réaction (K).

5. Procédé d'épitaxie en phase gazeuse selon une des revendications précédentes, **caractérisé en ce qu'**un substrat III-V possédant une concentration d'agent de dopage (D_{SUB}) d'au moins 1·10¹⁷ cm⁻³ ou d'au moins 1.10¹⁸ cm⁻³ est préparé.

6. Procédé d'épitaxie en phase gazeuse selon une des revendications précédentes, **caractérisé en ce que** la couche III-V est développée avec une épaisseur de couche (d_{L}) de 30 µm maximum.

7. Procédé d'épitaxie en phase gazeuse selon une des revendications précédentes, **caractérisé en ce que** le premier type de conductivité est p ou n.

8. Procédé d'épitaxie en phase gazeuse selon une des revendications précédentes, **caractérisé en ce que** la couche III-V est développée par continuité de matière sur la surface du substrat III-V (S).

9. Procédé d'épitaxie en phase gazeuse selon une des revendications précédentes, **caractérisé en ce que** la concentration d'agent de dopage (Dₘᵢₙ, Dₘₐₓ) à l'intérieur de la couche III-V est ajustée par le biais d'un rapport d'un flux massique du premier précurseur avec un flux massique du deuxième précurseur et/ou par le biais d'un flux massique du troisième précurseur ajouté au flux gazeux de l'épitaxie.

10. Procédé d'épitaxie en phase gazeuse selon une des revendications précédentes, **caractérisé en ce que** le troisième précurseur est du diméthyle de zinc ou du diéthyle de zinc ou du tétrabromure de carbone ou du 1,2-biscyclopentadiényle-magnésium ou du monosilane ou du disilane ou du tellurure de diéthyle ou du tellurure de diisopropyle.

11. Procédé d'épitaxie en phase gazeuse selon une des revendications précédentes, **caractérisé en ce que** le substrat III-V (S) présente sur une épaisseur de couche une concentration d'agent de dopage constante ou une concentration d'agent de dopage variant de 1% maximum.

12. Procédé d'épitaxie en phase gazeuse selon une des revendications précédentes, **caractérisé en ce que** le substrat III-V contient du GaAs ou est constitué de GaAs.

13. Procédé d'épitaxie en phase gazeuse selon une des revendications précédentes, **caractérisé en ce que** la température d'épitaxie T_{E} est de 550 °C minimum ou de 600 °C minimum et de 900 °C maximum.

14. Procédé d'épitaxie en phase gazeuse selon une des revendications précédentes, **caractérisé en ce que** l'ajout du troisième précurseur pendant le chauffage commence à partir d'une température d'au moins 150 °C ou au moins à partir d'une température de 200 °C.
